Europäisches Patentamt

European Patent Office

Office européen des brevets

(19)

(11) Veröffentlichungsnummer: **0 060 342
B1**

(12) **EUROPÄISCHE PATENTSCHRIFT**

(45) Veröffentlichungstag der Patentschrift:
11.09.85

(21) Anmeldenummer: **81110181.5**

(22) Anmeldetag: **05.12.81**

(51) Int. Cl.⁴: **H 03 K 5/02,** H 03 G 3/00,
H 03 K 5/08

(54) **Pegelumsetzer.**

(30) Priorität: **13.03.81 DE 3109711**

(43) Veröffentlichungstag der Anmeldung:
**22.09.82 Patentblatt 82/38**

④ Bekanntmachung des Hinwelses auf die Patenterteilung:
**11.09.85 Patentblatt 85/37**

(84) Benannte Vertragsstaaten:
**DE FR GB**

(56) Entgegenhaltungen:
**EP - A - 0 031 582
DE - A - 2 137 249
DE - A - 2 923 780
DE - A - 2 929 279
FR - A - 2 308 175**

**FUNKSCHAU, Band 52, Nr. 17, August 1980, Selten
75-78, München, DE. H. KELLER et al.:
"FM/AM-precelver RP 102"**

(73) Patentinhaber: **ROBERT BOSCH GMBH, Postfach 50,
D-7000 Stuttgart 1 (DE)**

(72) Erfinder: **Roth, Rolf, Keplerweg 59, D-7310 Plochingen
(DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung geht aus von einer Vorrichtung zur Pegelumsetzung von digitalen Signalen nach der Gattung des Hauptanspruchs. Pegelumsetzer mit im Gegentakt geschalteten Transistorendstufen sind allgemein bekannt. Aus der Entgegenhaltung Funkschau Band 52, Nr. 17, August 1980, Seiten 75 bis 78 ist es bekannt, für die elektronische Lautstärkeeinstellung in einem Rundfunkempfänger einen Digital-Analog-Wandler einzusetzen, der von einem Rechner gesteuert ist. Damit ist es möglich, die Lautstärke des Empfängers stufenlos zu verstellen. Die dort gezeigte Anordnung ist jedoch als Pegelumsetzer nicht geeignet. Es sind keine Hinweise zu entnehmen, wie eine Pegelumsetzung von digitalen Signalen bei einer im Gegentakt geschalteten Transistorendstufe vorzunehmen sind.

### Vorteile der Erfindung

Die erfindungsgemäße Vorrichtung mit den kennzeichnenden Merkmalen des Hauptanspruchs hat demgegenüber den Vorteil, daß beide Ausgangspegel unabhängig voneinander einstellbar sind. Als weiterer Vorteil ist anzusehen, daß bei der Verwendung von Digital-Analog-Wandlern die Spannungspegel in digitaler Form mittels eines Mikroprozessors oder mittels Schaltern vorgebbar sind. Dies ermöglicht eine einfache und reproduzierbare Einstellung der unterschiedlichen Pegel, wobei der Pegel des Pegelumsetzers in Abhängigkeit von der verwendeten Technologie auch fremd zu steuern ist.

Besonders vorteilhaft ist es, die Transistorendstufe aus komplementären VMOS-Transistoren zu bilden. VMOS-Transistoren haben den Vorteil, daß sie kurze Schaltzeiten aufweisen und kein Speichereffekt auftritt, so daß sehr hohe Schaltfrequenzen zu erreichen sind und steile Impulsflanken auftreten. Zu dem ist bei VMOS-Transistoren das Gate vom Kanal isoliert, so daß eine leistungslose Ansteuerung möglich ist. Die Schaltungsanordnung eignet sich besonders für Prüfvorrichtungen für digitale Schaltungen, bei denen Schaltungen mit unterschiedlicher Technologie, wie beispielsweise TTL-, CMOS- und ECL-Schaltungen, Verwendung finden. In weiterer Ausbildung der Erfindung ist es vorteilhaft, wenn die Gleichspannungsquellen in Abhängigkeit von der Versorgungsspannung der zu speisenden Schaltkreise eingestellt sind.

### Zeichnung

Ein Ausführungsbeispiel der Erfindung ist in der Zeichnung dargestellt und in der nachfolgenden Beschreibung näher erläutert. Es zeigt die
Fig. 1 ein Ausführungsbeispiel mit Digital-Analog-Wandlern als Gleichspannungsquellen und

Fig. 2 ein Impulsdiagramm mit verschiedenen einstellbaren Impulsformen.

### Beschreibung des Ausführungsbeispiels

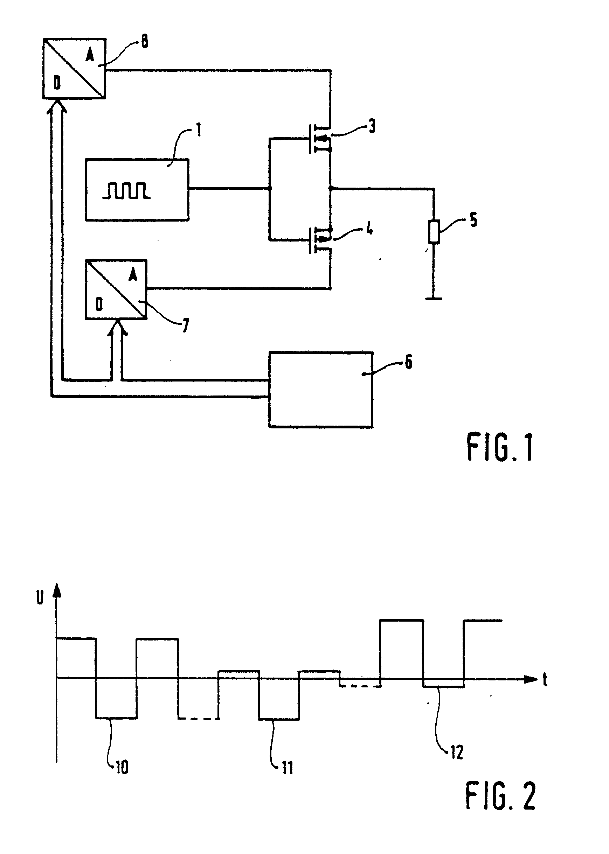

Fig. 1 zeigt einen Rechteckgenerator 1, der jeweils das Gate eines VMOS-Transistors 3 und 4 speist. Ein Kanalausgang eines jeden VMOS-Transistors 3 und 4 ist miteinander verbunden und einem Lastwiderstand 5 zugeführt, der seinerseits mit der gemeinsamen Masseleitung in Verbindung steht. Von einem Mikroprozessor 6 führt ein Datenbus zu jeweils einem Digital-Analog-Wandler 7 und 8. Von einem Digital-Analog-Wandler 7 führt eine Leitung zum Kanaleingang eines VMOS-Transistors 4, während ebenso der Digital-Analog-Wandler 8 mit einem Kanaleingang des VMOS-Transistors 3 in Verbindung stehen.

Bei der gezeigten Vorrichtung handelt es sich um eine Prüfvorrichtung für digitale Schaltkreise. Soll die Vorrichtung allgemein als Pegelumsetzer Verwendung finden, ist statt des Rechteckgenerators 1 das Ausgangssignal einer digitalen Schaltungsanordnung anschließbar. Der Rechteckgenerator 1 steuert die Gates der VMOS-Transistoren 3 und 4 an, die komplementär sind und im Gegentakt schalten. Gibt der Rechteckgenerator einen positiven Spannungswert ab, so ist der VMOS-Transistor 3 leitend und der VMOS-Transistor 4 gesperrt, während der Transistor 4 leitend ist und der Transistor 3 gesperrt ist, wenn vom Rechteckgenerator ein negativer Spannungswert abgegeben wird. Der Lastwiderstand 5 repräsentiert die Belastung der Gegentaktendstufe durch die nachgeschaltete Baugruppe. Am Lastwiderstand 5 sind Impulsgruppen abnehmbar, die beispielhaft in der Fig. 2 dargestellt sind. Der obere Spannungswert der Impulse ist durch die Gleichspannung bestimmt, die durch den Digital-Analog-Wandler 8 abgegeben wird. Der untere Spannungspegel ist durch die Gleichspannung bestimmt, die durch den Digital-Analog-Konverter 7 abgegeben wird. Jeder Spannungspegel entspricht einem digitalen Wort, das vom Mikroprozessor 6 ausgegeben wird. Bei der Verwendung von VMOS-Transistoren 3 und 4 kann die Gleichspannung der Digital-Analog-Wandler 7 und 8 sowohl positive als auch negative Spannungswerte annehmen, da der Kanal der VMOS-Transistoren 3 und 4 mittels Spannung am Gate gesteuert wird und das Gate vom Kanal isoliert ist. Durch eine entsprechende Programmierung des Mikroprozessors kann erreicht werden, daß beim Einbringen von zu prüfenden elektrischen Baugruppen durch Steuerbefehle oder durch die Betriebsspannung erkannt werden kann, welche Ausgangspegel von der Gegentaktendstufe abgegeben werden müssen.

Weiterhin ist es möglich, an den Digital-Eingang der D/A-Wandler 7 und 8 Schalter anzuschließen, mit denen die entsprechenden Pegelwerte in digitaler Form vorgegeben werden können. Für die Gegentaktschaltung mit den Transistoren 3 und 4 sind beliebige Transistoren entsprechender Leistungsfestigkeit verwendbar. Die Verwendung von VMOS-Transistoren hat jedoch den Vorteil, daß sehr kurze Schaltzeiten erzielbar sind, kein Speichereffekt auftritt, so daß hohe Schaltfrequenzen erreicht werden, und daß das Gate vom Kanal isoliert ist, so daß positive und negative Gleichspannungen anlegbar sind.

Die Fig. 2 zeigt drei Impulsgruppen 10, 11 und 12, die durch den Pegelwandler erzeugbar sind. Die Impulsgruppe 10 ergibt sich dann, wenn die Digital-Analog-Wandler 7 und 8 betragsmäßig nahezu die gleiche Spannung abgeben. Die Impulsgruppe 11 entsteht, wenn vom Digital-Analog-Wandler 8 nur eine geringe positive Spannung abgegeben wird, während die Impulsgruppe 12 entsteht, wenn der Digital-Analog-Wandler 7 nur eine geringe negative Spannung, der Digital-Analog-Wandler 8 jedoch eine große positive Spannung abgibt.

## Patentansprüche

1. Vorrichtung zur Pegelumsetzung von digitalen Signalen mit einer im Gegentakt geschalteten Transistorendstufe (3, 4), dadurch gekennzeichnet, daß die Transistorendstufe (3, 4) beidseitig von einer veränderbaren Gleichspannungsquelle (7, 8) gespeist ist, daß mindestens eine der Gleichspannungsquellen einen Digital-Analog-Wandler (7, 8) aufweist und daß die Digital-Analog-Wandler (7, 8) von einem Mikroprozessor (6) oder von Schaltern steuerbar sind.

2. Vorrichtung nach Anspruch 1, dadurch gekennzeichnet, daß die Transistorendstufe aus komplementären VMOS-Transistoren (3, 4) gebildet ist.

3. Vorrichtung nach Anspruch 1 oder 2, dadurch gekennzeichnet, daß die Vorrichtung bei Prüfvorrichtungen für digitale Schaltungen Verwendung findet.

4. Vorrichtung nach einem der vorhergehenden Ansprüche, dadurch gekennzeichnet, daß die Gleichspannungsquellen (7, 8) in Abhängigkeit von der Versorgungsspannung einer der Vorrichtung nachgeschalteten digitalen Schaltungsanordnung eingestellt sind.

## Claims

1. Device for converting the level of digital signals, comprising a push-pull-connected transistor output stage (3, 4), characterized in that the transistor output stage (3, 4) is fed on both sides by a variable direct-voltage source (7, 8) and that at least one of the direct-voltage sources is provided with a digital/analog converter (7, 8) and that the digital/analog converters (7, 8) can be controlled by a microprocessor (6) or by switches.

2. Device according to claim 1, characterized in that the transistor output stage is formed by complementary VMOS transistors (3, 4).

3. Device according to claim 1 or 2, characterized in that the device is used in testing devices for digital circuits.

4. Device according to one of the preceding claims, characterized in that the direct-voltage sources (7, 8) are adjusted in dependence on the supply voltage of a digital circuit arrangement following the device.

## Revendications

1. Convertisseur de niveau de signaux numériques avec un étage à transistors commutés en opposition de cadence (3, 4) caractérisé en ce que l'étage à transistors (3, 4) est alimenté des deux côtés par une source de tension continue variable (7, 8), en ce qu'au moins l'une des sources de tension continue comporte un convertisseur numérique/analogique (7, 8) et en ce que les convertisseurs numériques/analogiques (7, 8) sont commandés par un microprocesseur (6) ou par des commutateurs.

2. Dispositif selon la revendication 1, caractérisé en ce que l'étage à transistors est formé de transistors complémentaires de type V-MOS (3, 4).

3. Dispositif selon les revendications 1 ou 2, caractérisé en ce qu'il est appliqué des dispositifs de contrôle pour des circuits numériques.

4. Dispositif selon l'une des revendications précédentes, caractérisé en ce que les sources de tension continue (7, 8) sont réglées en fonction de la tension d'alimentation d'un circuit numérique en aval du dispositif.

FIG.1

FIG. 2